# EUROPEAN PATENT APPLICATION

(11) **EP 0 946 010 A2**
(43) Date of publication of application: **29.09.1999**
(21) Application number: 99301949.6
(22) Date of filing: 15.03.1999
(51) Int. Cl.: H04H 1/00, H04B 1/16, H03J 1/00

(54) **Receiver for receiving digital broadcast programmes**

(30) Priority: 23.03.1998 JP 9402398
(71) Applicant: PIONEER ELECTRONIC CORPORATION, Meguro-ku, Tokyo (JP)
(72) Inventor: Ichikawa, Toshihito, Pioneer Electronic Corp., Kawagoe-shi, Saitama (JP); Uchiyama, Kazuhiko, Pioneer Electronic Corp., Kawagoe-shi, Saitama (JP)
(74) Representative: Haley, Stephen

(57) **Abstract**

In a digital broadcast receiver which can prevent the mission of information due to a SAW filter, the ratio in demultiplying a frequency of PLL is controlled based upon a calculated frequency offset and a frequency oscillated by VCO is adjusted so that a frequency offset input via a filter does not exceed predetermined quantity.

## Description

The present invention relates to a digital broadcast receiver, particularly to a receiver for receiving a digital audio broadcast (DAB) which is already at a practical stage in Europe.

For a system for sending or receiving a broadcast wave provided with a data signal according to a predetermined format including a digital audio signal, there is a DAB system determined by Eureka 147 project. In DAB, one ensemble is composed of plural services and each service is also composed of plural components such as English and German.

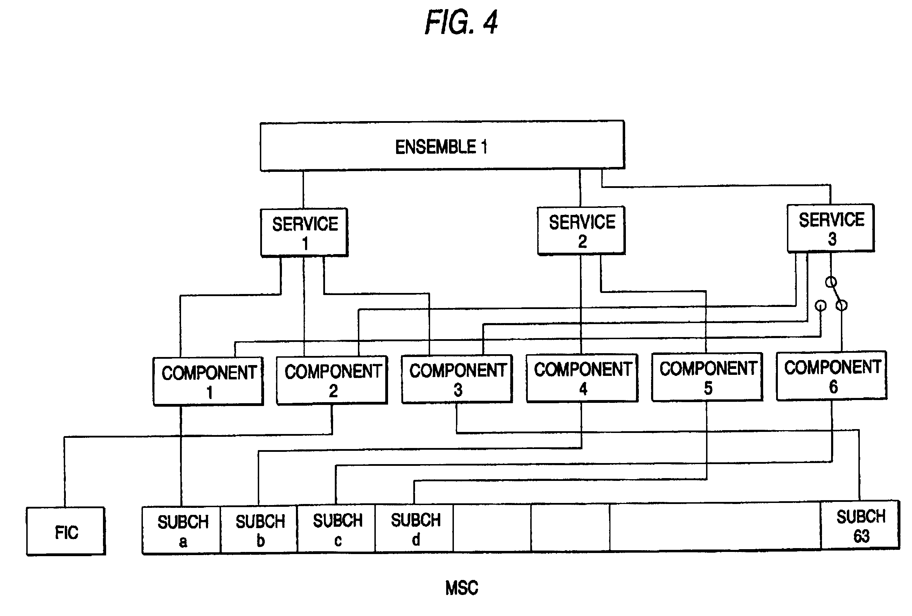

Fig. 4 shows an example of the configuration of service in the DAB system and shows a link among services constituting an ensemble 1 (three in Fig. 4), each component (six in Fig. 4) and an orthogonal frequency division multiplex (OFDM) signal actually transmitted from a DAB station.

An OFDM signal transmitted from a DAB station is divided into a fast information channel (FIC) and a main service channel (MSC).

Each subchannel (Subchannels 1 to 63) constituting MSC corresponds to the above each component, and the information of services available in the ensemble and information showing a link among services, components and subchannels are included in FIC.

Therefore, in DAB, if an ensemble is received, information related to plural services and components included in the ensemble can be acquired and the current service or component can be instantaneously switched to a different service or component without changing a received frequency.

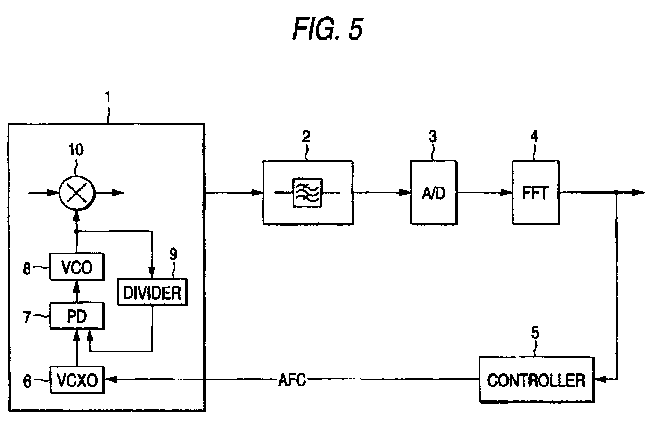

Fig. 5 shows the schematic configuration of a DAB receiver for receiving a digital broadcast. In Fig. 5, a mechanism particularly related to the present invention for correcting a frequency offset is mainly shown.

The DAB receiver is composed of a tuner 1, a surface acoustic wave (SAW) filter 2, an analog-to-digital (A/D) converter 3, a fast Fourier transform (FFT) circuit 4 and a controller 5.

In the tuner 1, a phase-locked loop (PLL) composed of a phase comparator 7, a voltage-controlled oscillator (VCO) 8 and a divider 9 is arranged and a reference signal equivalent to the integer times of output from a voltage-controlled crystal oscillator (VCXO) 6 is supplied to a mixer 10. Frequency conversion is executed based upon a received signal and the above reference signal to generate an intermediate frequency (IF) signal.

The SAW filter 2 extracts an IF signal out of the output of the mixer 10 according to predetermined selectivity. The extracted IF signal is output to the subsequent A/D converter 3.

In the A/D converter 3, the IF signal is converted to a digital signal. The IF signal which is converted to a digital value by the A/D converter 3 is input to the FFT circuit 4 for demodulating an orthogonal frequency division multiplex (OFDM) signal.

In the FFT circuit 4, a predetermined FFT window for an input signal is provided to execute FFT processing. Each phase information of multiple carriers can be acquired by such processing. The result of the FFT processing is output to subsequent Viterbi decoder not shown and is also output to the controller 5.

The controller 5 calculates the quantity of the frequency offset of an input signal based upon the result of FFT for a reference symbol included in a DAB signal, generates an automatic frequency control (AFC) signal based upon the result of the calculation and outputs it to the tuner 1.

Synchronization with a received signal can be established and maintained by adjusting the oscillation frequency of VCXO of the tuner 1 to be synchronized with the oscillation frequency of a transmitter using the above AFC signal. The above description relates to the outline of the receiver.

The above contents are also disclosed in Nikkei Electronics published in 1995.

However, for a method of adjusting the above frequency offset used for an initial DAB receiver, the change of the carrier-to-noise ratio (CN ratio) of the receiver is large and CN ratio is unstable because VCXO itself is controlled.

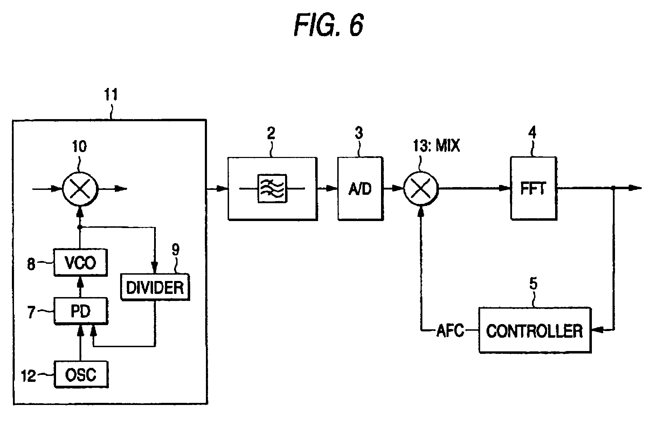

Currently, a method of correcting a frequency offset using a digital stage is proposed. Fig. 6 shows the outline of a DAB receiver using such a method. The same reference number is allocated to the same part as that shown in Fig. 5 and the description is omitted.

Fig. 6 is different from Fig. 5 in that frequency conversion by the mixer is also enabled at the digital stage. Fig. 6 shows an example in which a digital mixer 13 for executing frequency conversion processing using digital technique is arranged between the A/D converter 3 and the FFT circuit 4.

The example is characterized in that as a control loop by AFC is constituted by the devices following the A/D converter 3 because of such configuration, an analog stage and a digital stage are readily separated and further, as a frequency-fixed oscillator 12 can be also used in a tuning stage 11 without requiring VCXO, the cost can be reduced and the CN radio of a receiver can be readily secured.

In the above method, however, as the frequency offset is not corrected before the SAW filter 2, it is possible that information attenuated (blocked) by the SAW filter 2 due to the frequency offset becomes error. Therefore, it the frequency offset is large, such error may not be corrected even if certain error correction is performed.

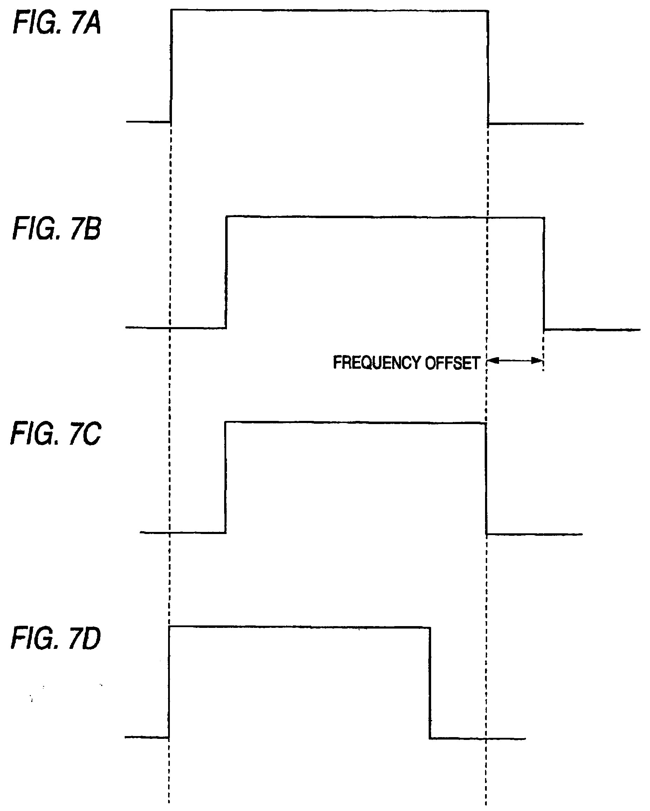

Figs. 7A to 7D show such a state, where Fig. 7A shows the frequency characteristic of the SAW filter 2 and Fig. 7B shows an IF signal input to the filter 2. Figs. 7A and 7B show a case where an IF signal is offset in the direction of higher frequency with respect to the filter characteristic.

As shown in Figs. 7A to 7D, if an IF signal is offset in a direction higher in a frequency, information in a part equivalent to the frequency offset is cut off by the SAW filter 2.

Therefore, for the output of the SAW filter 2, a part of an IF signal is missing as shown in Fig. 7C and the incomplete signal is supplied to the mixer 13. As the controller 5 controls to correct the frequency offset in the mixer 13, a digital IF signal output from the mixer 13 is as shown in Fig. 7D as a result.

As described above, if an IF signal is off the frequency band of the filer, on one hand, a part of an input signal is cut off and required information cannot be transmitted to the latter stage as apparent from Fig. 7C and on the other hand, a signal from an adjacent station passes the filter.

This phenomenon becomes remarkable in case a received frequency is high as in L band (the band of 1.5 GHz) and a problem such as the distortion of a signal waveform and the deterioration of a selectivity characteristic occurs.

Therefore, an object of the present invention is to provide a digital broadcast receiver wherein the missing of information by a filter can be prevented.

According to a first aspect of the present invention, there is provided a digital broadcast receiver, comprising:
a reference signal generator including a phase-locked loop (PLL), for generating a reference signal;
a first frequency converter for generating an intermediate-frequency (IF) signal based upon a received signal and the reference signal;
a filter for passing the IF signal output from the first frequency converter;
a fast Fourier transform (FFT) circuit for executing the fast Fourier transform of the output of said filter;
frequency offset calculation means for calculating frequency offset of the received signal based upon an output of said FFT circuit;
judging means for judging whether or not the frequency offset exceeds a predetermined quantity; and
frequency changing means for changing frequency of the reference signal by changing a dividing ratio of the PLL in case the frequency offset is judged to exceed the predetermined quantity.

According to a second aspect of the present invention, there is provided the digital broadcast receiver according to the first aspect of the invention, wherein said predetermined quantity is equivalent to 1/2 of a frequency step of PLL.

According to a third aspect of the present invention, there is the digital broadcast receiver according to the first aspect of the invention, further comprising a second frequency converter, provided after the filter, for generating a second intermediate-frequency (IF) signal based on the IF signal;
wherein the second frequency converter suppresses the frequency offset to approximately zero in case the frequency offset does not exceed the predetermined quantity.

According to a fourth aspect of the present invention, there is provided the digital broadcast receiver according to the first aspect of the invention, wherein a frequency offset is calculated based upon the output of a reference symbol used in a digital broadcast from the FFT circuit.

In the drawings:

The above and other objects and features of the present invention will be more apparent from the following description taken in conjunction with the accompanying drawings.
Fig. 1 is a block diagram showing a digital broadcast receiver according to a first embodiment of the present invention;
Figs. 2A to 2D show the operational principle of AFC according to the present invention;
Fig. 3 is a flowchart for AFC executed by a controller;
Fig. 4 shows an example of the configuration of service in a DAB system;
Fig. 5 shows the schematic configuration of a conventional type DAB receiver;
Fig. 6 shows the schematic configuration of a conventional type DAB receiver; and
Figs. 7A to 7D show the operational principle of conventional type AFC.

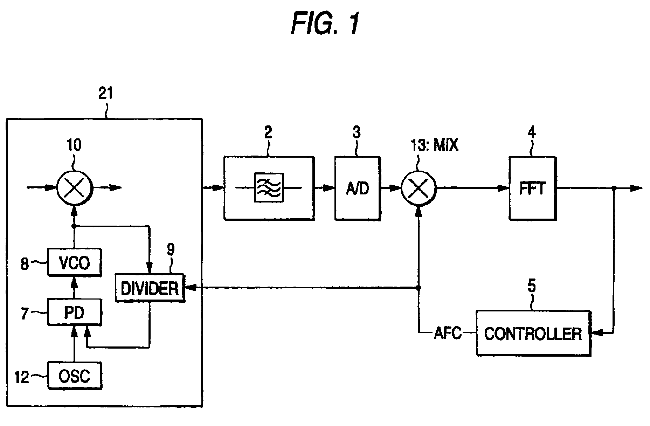

Referring to the drawings, an embodiment of the present invention will be described in detail below. Fig. 1 is a block diagram showing a DAB receiver equivalent to an embodiment of the present invention. The same reference number is allocated to the same part as that in Fig. 6 and the detailed description is omitted.

Mainly explaining different points, this embodiment is characterized in that a frequency offset exceeding predetermined quantity is corrected in the former stage of a SAW filter 2 and a frequency offset smaller than or equal to the predetermined quantity is corrected in the latter stage of the SAW filter 2.

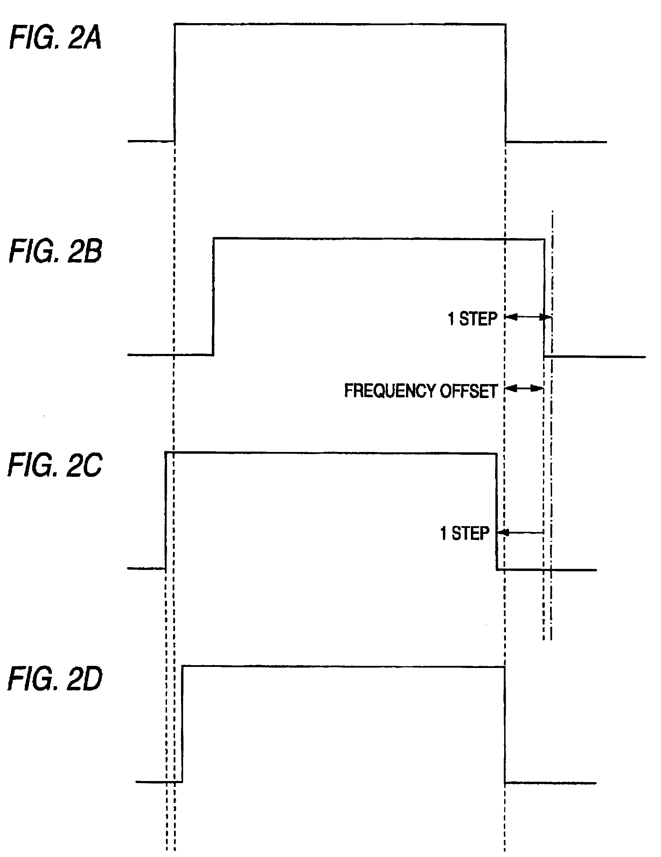

Figs. 2A to 2D show the operational principle of the present invention, in which Fig. 2A shows the frequency characteristic of the SAW filter 2, and Fig. 2B shows an IF signal input to the filter. Figs. 2A to 2D show a case that an IF signal is off in the direction of a higher frequency than a filter characteristic.

In the present invention, first, as shown in Fig. 2B, it is judged whether or not the calculated quantity of a frequency offset is larger than 1/2 of one step (in more detail, as a frequency step in a DAB broadcast is 16 kHz, one step of PLL is also set to 16 kHz) of PLL in a tuner 21.

As a result of the judgment, if it is judged that the calculated quantity of a frequency offset is larger than 1/2, the quantity of a frequency offset in the former stage of the SAW filter is adjusted to 1/2 of a frequency step of PLL or less by shifting a frequency step of PLL by one step as shown in Fig. 2C.

Next, as shown in Fig. 2D, a frequency offset component which cannot be corrected in such adjustment is corrected based upon a newly calculated quantity of a frequency offset using the digital mixer 13 by the same method as that shown in Fig. 6. The above description relates to an operational principle.

As described above, the present invention is different from the configuration shown in Fig. 5 in which a frequency offset is completely corrected at the former stage of the SAW filter 2 by directly controlling VCXO. In the present invention, an offset exceeding predetermined quantity is prevented from being caused by controlling the step of PLL.

Therefore, the missing of information due to the filter can be suppressed and such missing can be securely compensated by error correction technique. Further, as VCXO is not directly controlled, variation of CN ratio can also be prevented.

Further, as a frequency offset smaller than or equal to predetermined quantity is corrected by the mixer 13 arranged in the latter stage the A/D converter as in Fig. 6, it can be completely corrected.

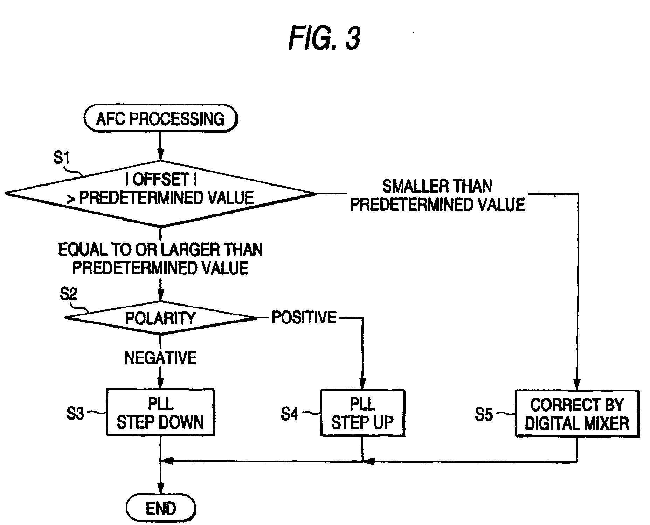

Next, a flowchart for control executed by the controller 5 based upon such a basic principle will be described. Fig. 3 is a flowchart for AFC executed by the controller 5 and this flowchart is executed every time the quantity of the frequency offset of an input signal is calculated based upon the result of FFT processing.

When the quantity of the frequency offset of an input signal is calculated, first, it is judged in step S1 whether or not the absolute value of the calculated quantity of its frequency offset exceeds a predetermined quantity.

If the frequency offset exceeds the predetermined quantity, the polarity of an error is judged in step S2. As an oscillation frequency of a receiver is lower than that of a transmitter in case the error of a frequency is judged positive, the controller controls in step S3 to increase the oscillation frequency of the receiver. Particularly, an oscillation frequency of VCO is increased by one step by changing the dividing ratio of the divider 9 for dividing the output of the VCO by one step.

Conversely, as an oscillation frequency of a receiver is higher than that of a transmitter in case the error of a frequency is judged negative, the controller controls the divider 9 in step S4 to reduce the oscillation frequency of the receiver is reduced.

In the meantime, if it is judged in the step S1 that the calculated quantity of a frequency offset is smaller than or equal to the predetermined quantity, processing for correcting the calculated quantity of the frequency offset using the digital mixer 13 is executed in step S5 as shown in Fig. 6.

A received signal can be securely synchronized by continuing the above processing.

As described above, according to the present invention, a frequency offset of the filter input is controlled in order not to exceed a predetermined quantity. Therefore, the deterioration of selectivity and the distortion of a signal due to the frequency offset can be suppressed to a level sufficient for practical use.

Further, frequency conversion means is provided at the latter stage of the A/D converter and the frequency offset is adjusted also by the frequency conversion means. Thus, remaining frequency offset smaller than or equal to the predetermined quantity can be corrected to approximately zero.

The foregoing description of a preferred embodiment of the invention has been presented for purposes of illustration and description. It is not intended to be exhaustive or to limit the invention to the precise form disclosed, and modifications and variations are possible in light of the above teachings or may be acquired from practice of the invention. The embodiment was chosen and described in order to explain the principles of the invention and its practical application to enable one skilled in the art to utilize the invention in various embodiments and with various modifications as are suited to the particular use contemplated. It is intended that the scope of the invention be defined by the claims appended hereto, and their equivalents.

## Claims

1. A digital broadcast receiver, comprising:
a reference signal generator including a phase-locked loop (PLL), for generating a reference signal;
a first frequency converter for generating an intermediate-frequency (IF) signal based upon a received signal and the reference signal;
a filter for passing the IF signal output from the first frequency converter;
a fast Fourier transform (FFT) circuit for executing the fast Fourier transform of the output of said filter;
frequency offset calculation means for calculating frequency offset of the received signal based upon an output of said FFT circuit;
judging means for judging whether or not the frequency offset exceeds a predetermined quantity; and
frequency changing means for changing frequency of the reference signal by changing a dividing ratio of the PLL in case the frequency offset is judged to exceed the predetermined quantity.

2. A digital broadcast receiver according to Claim 1, wherein said predetermined quantity is equivalent to 1/2 of a frequency step of said PLL.

3. A digital broadcast receiver according to Claim 1, further comprising a second frequency converter, provided after the filter, for generating a second intermediate-frequency (IF) signal based on the IF signal;
wherein the second frequency converter suppresses the frequency offset to approximately zero in case the frequency offset does not exceed the predetermined quantity.

4. A digital broadcast receiver according to Claim 1, wherein said frequency offset is calculated based upon the output of a reference symbol used in said digital broadcast from the FFT circuit.
